# EUROPEAN PATENT APPLICATION

(11) **EP 0 917 413 A2**
(43) Date of publication of application: **19.05.1999**
(21) Application number: 98308999.6
(22) Date of filing: 03.11.1998
(51) Int. Cl.: H05K 3/00, H05K 1/02, C08J 3/28

(54) **Process for promoting chemical adhesion of legend inks using ultra-violet light**

(30) Priority: 10.11.1997 US 966675
(71) Applicant: GENERAL ELECTRIC COMPANY, Schenectady, NY 12345 (US)
(72) Inventor: Holder, Timothy A., Coshocton, Ohio 43812 (US)
(74) Representative: Szary, Anne Catherine, Dr.

(57) **Abstract**

The present invention relates to an improved method for affixing inks to thermoplastics such as the laminates used in printed circuit boards wherein the laminate is briefly exposed to an intense ultraviolet source. Legend inks that would normally fail to bond to the surface of such laminates without UV pretreatment instead exhibit outstanding bonding strength following such UV treatment.

## Description

This invention relates to and discloses a method for improving the bonding between legend inks and printed circuit boards. More particularly, the invention relates to a process for promoting the chemical adhesion of legend inks to printed circuit boards through the use of ultra-violet (UV) light.

### BACKGROUND OF THE INVENTION

Printed circuit boards manufactured in the world today are of two types -- double clad (copper on both sides) and single sided (copper on one side). Normally, single sided laminates will have a pattern screen printed onto the unclad side of the laminate. This pattern is used as a parts indicator in the event that the circuit board becomes defective at a later time and needs to be replaced.

Single sided printed circuit boards are usually manufactured with the unclad side against a bare stainless steel pan with a release coating on the plate or by using a release sheet between the resin and the steel pan. This assures that the pressed laminate will come apart from the stainless steel plate. There are usuallv two surface types generated from these two methods of laminate releasing, one surface will have a low gloss, rough finish and the other.will take on the glossy surface that is created by the polished steel pan. The panel with the rough topography will have excellent mechanically bonding strength as far as the bonding of UV curable inks. In contrast, the panel with the glossy surface will have very few mechanical bonding sites. This condition inhibits proper bonding of the UV curable inks.

Most laminators of single sided materials will either use a release sheet and avoid the printability problem (very costly to the product), or they will mechanically scrub the unclad side with rotating brushes and usually an abrasive grit slurry. This will assure a good mechanical bonding site for the legend ink to adhere to . Normally brushing can be very costly in the use of pumice, brushes, water, steam, electricity and disposal of the used pumice. Other cost factors are a slow down in production due to the brushing operation itself. From a quality side, brushing the unclad surface exposes glass bundles of the weave which allows moisture to enter the laminate more readily and also allows solder to stick to the unclad surface which is undesirable to the customer.

Printed circuits are typically prepared by adhering conductive traces which form an electrical interconnect pattern onto a suitable substrate. Commonly-employed substrate materials have included epoxy-glass laminate, paper-phenolic laminate, polyamide-glass laminate, flexible polyamide films, and injection molded plastics such as liquid crystal polymers. Copper foil has most successfully been used to form conductive traces on these substrates, in particular because of its high electrical conductivity and the strong bond formed when the copper foil is laminated to the substrates

After printing the uncured composition in the pattern of the desired printed circuit on the substrate, the composition is then cured by application of heat. A static oven may be employed, but an oven with multiple heating stages is preferred. The oven's heating method may be infra-red lamps, panel heaters, convection, forced hot air, induction, microwave, or other known heating method. Such ovens are well known to those skilled in the art. The multiple heating stages may then be used to heat, dry, cure, and then cool the composition in a controlled way, minimizing pinholes caused by out gassing, eliminating damage due to severe temperature changes, and achieving complete curing. Holes may be drilled or punched in the printed circuit thus obtained, as in a conventional circuit board. Components may be soldered to the printed circuit with a solder wave, soldering iron, hot air gun, or solder paste reflow, all common techniques well known in the art. Alternatively, components may be adhered to the printed circuit using the composition itself. This is accomplished, for example, by placing the components in the composition prior to curing. This has the advantage of eliminating the soldering operation and subsequent solder flux cleaning operations entirely. Yet another method for adhering components is to first cure the printed circuit, then apply an additional amount of uncured composition as a conductive adhesive for bonding the components.

Multiple-layer printed circuits may be made by starting with a circuit board made as above. Over the cured composition and prior to soldering of the circuit components, a thin layer of a non-conductive insulating thermosetting resin is applied with a screen or stencil printer. The layer applied should be patterned so as to allow vias or passages which remain uncoated with insulating material. After curing of this layer, a second layer of conductive composition, in the desired printed circuit pattern, may be printed over the insulating layer. The vias or passages would then allow electrical interconnection between the upper and lower layers. In this fashion. a two-layer printed circuit is made. The process may then be repeated multiple times to create a printed circuit containing a plurality of layers. Electronic components may then be attached as described before as well as by means of phenolic and anhydride cured resin systems. However, such systems usually have poor chemical bonding capabilities when utilized in conjunction with laminate surfaces. Additionally, copper peel strength and legend bonds are generally lower than a DiCy cured system.

Moreover, the soldering of electrical components to a printed circuit board is a multi-step, time consuming task. More precisely, before the electrical components can be soldered to the board, the following steps are typically carried out. One starts with an insulating board such as epoxy fiberglass board which may or may not be copper-clad. The board is then drilled at predetermined sites where the land holes will be. The boards are then deburred and cleaned and, if clad, the cladding is washed in ammonium persulfate solution and then in water (5-10% H2SO4 solution) or other solvent to remove excess ammonium persulfate. A catalyst is then applied to the board for electroless deposition of copper to coat not only the inside of the drilled holes, but also the entire board. Following electroless deposition of copper, additional copper may be put on the board and in the holes by electroplating. The board is then covered with a photo resistant and exposed imagewise through a printed circuit transparency to UV light, thus curing (hardening) the exposed portion of the photo resist. The unexposed portion of the photo resist is washed off, exposing the copper thereunder, i.e., where the lands, wiring conductors and connecting pads are formed in the case of "plated" boards. Positive working resists can also be used if desired at this stage. Alternatively, the board can be coated imagewise with a screenable resist via screen printing techniques, with the resist cured, either by heat in the case of "conventional" resists, or by UV radiation in the case of photopolymer resists.

The thus exposed copper circuit can then be electroplated in a tin-lead plating bath, thereby coating solder onto the exposed copper on the board and in the holes. The cured photo resist is then stripped in a solvent and/or by mechanical means and the copper under the cured photo resist is etched away in a conventional copper etching bath.

Alternatively, the board can be plated with a combination of other metals, including nickel, gold, rhodium, etc.

As an alternative to the plated board, the "print and etch" variety of board is often used in entertainment circuitry. These boards are imaged with photo resist in the same manner, but in the negative image of the "plated" boards. The exposed copper represents superfluous copper outside of the land areas, wiring conductors and connector pads and can now be etched away. The resist is then removed.

Yet another method for creating a multiple-layered printed circuit is to begin with a series of thin substrates with vias or passages drilled or punched therein. The conductive composition is then screen or stencil-printed onto each of these substrates in the desired printed circuit pattern, each layer generally being different. The compositions may then be cured, or simply dried and left uncured while the thin substrates are aligned and laminated together under pressure. The laminating pressure will force the conductive layers to interconnect through the vias and passages in the thin substrates, interconnection being made wherever there exists conductive composition directly beneath a via or passage. Curing of the composition may be done before, during or after this laminating process. The result is a multiply-layered printed circuit.

Printed circuit boards have also been prepared by a process which comprises applying copper plating onto a copper foil plated, laminated plate, laminating thereon a photosensitive film, exposing the photosensitive film to light through a photographic negative, and removing the unexposed portion, followed by etching away any unnecessary copper foil part not under a circuit pattern, and by removing the photosensitive film to form a printed circuit on the insulated laminated plate. The photosensitive film used in this process raises the problem that the circuit pattern formed by exposing to light and developing is not sharp because the film is so thick, normally in the neighborhood of 50 microns, that it is difficult to uniformly laminate the photosensitive film on the surface of the copper foil. The photosensitive film is mostly removed uselessly in spite of being expensive.

All of these processes leave a printed wiring board ready for solder masking and legend ink marking. At this point, depending on the specific sequence in which the particular manufacturer of printed wiring boards operates, the solder mask can first be applied followed by legend ink application, or the reverse, or the legend ink only can be applied.

Legend or marking inks are applied to circuit boards to indicate proper positioning of components which are soldered or otherwise affixed thereto. Prior art legend inks include both the solvent type wherein only a portion of the ink is actually cured on the circuit board and the solvent is removed and legend inks wherein 100% of the material is cured on the board. Both these type inks have serious drawbacks. For example. in the solvent type legend ink the material has a tendency to dry out (evaporation of solvent) on the screen when being printed on the board, thus resulting in a clogging of the screen in subsequent applications with resultant non-uniform lay down. Further, the evaporation of the solvent causes pollution problems. A further problem due to evaporation of the solvent is the change in viscosity causing the ink to become thicker which also results in non-uniformity. Obviously, a further drawback is that, due to solvent evaporation, the thickness you print is not the thickness you get. The solvent type legend inks also are cured by heat. This usually requires removing the boards from the line, racking them and passing them to ovens wherein they remain for several hours to obtain a cure. Thus, not only is more energy consumed but also line speeds are decreased due to the necessity of racking and oven-curing for extended times.

Further, variable information such as production date, lot number, batch number, serial number, and the like. are presently placed on individual circuit boards by hand. also using legend inks.

Ink jet printing and ink compositions which permit ink to be jetted from an ink jet printer offer a means for preparing circuit boards of increasing density and printing variable information on a circuit board. Ink jet printing is a non-impact technique for projecting droplets of ink onto a substrate. There are two major categories of ink jet printing, "Drop-On-Demand" ink jet and "Continuous" ink jet. Using Drop-On-Demand ink jet technology, the ink is normally stored in a reservoir and delivered to a nozzle in the print head of the printer. A means exists to force a single drop ofink out of the nozzle whenever it is needed to print a single spot on the printed medium (for example, paper). For Continuous ink jet, a conducting ink is supplied under pressure to an ink nozzle and forced out through a small orifice, typically 35 to 80 microns in diameter. Prior to passing out of the nozzle, the pressurized ink stream proceeds through a ceramic crystal which is subjected to an electric current. This current causes a piezoelectric vibration equal to the frequency of the AC electric current. This vibration, in turn, generates the ink droplets from the unbroken ink stream. The ink stream breaks up into a continuous series of drops which are equally spaced and of equal size. Surrounding the jet, at the point where the drops separate from the liquid stream in a charge electrode, a voltage is applied between the charge electrode and the drop stream. When the drops break off from the stream each drop carries a charge proportional to the applied voltage at the instant at which it breaks off. By varying the charge electrode voltages at the same rate as drops are produced it is possible to charge every drop to a predetermined level. The drop stream continues its flight and passes between two deflector plates which are maintained at a constant potential, typically + / - 2.5 kV. In the presence of this field, a drop is deflected towards one of the plates by an amount proportional to the charge carried. Drops which are uncharged are undeflected and collected into a gutter to be recycled to the ink nozzle. Those drops which are charged, and hence deflected, impinge on a substrate traveling at a high speed at right angles to the direction of drop deflection. By varying the charge on individual drops. the desired pattern can be printed.

The ink jet process is adaptable to computer control for high speed printing of continuously variable data. Ink jet printing methods can be divided into three general categories: high pressure, low pressure and vacuum techniques. All have been described and employed in conventional ink jet printing and can be employed in the present invention.

Reviews of various aspects of conventional ink jet printing can be found in these publications: Kuhn et al., Scientific American, April, 1979, 162-178 and Keeling, Phys. Technol., 12(5), 196-303 (1982). Various ink jet apparatuses are described in U.S. Pat. No. 3,060,429, U.S. Pat. No. 3,298,030, U.S. Pat. No. 3,373,437, U.S. Pat. No. 3,416,153 and U.S. Patent No. 3,673,601.

### SUMMARY OF THE INVENTION

The present invention is described to an improved method (and the articles made by such method) for affixing legend inks to laminates such as those used in the manufacture of printed circut boards.

Presently, laminates are mechanically scrubbed using an abrasive grit slurry to provide the rough surface needed for bonding sites for the legend inks. It has now been discovered that a roughened surface is not the only way in which good chemical and mechanical bonding between ink and laminate may be effectuated. By briefly exposing the unclad surface of a printed surface board to an intense (i.e., 100-400 watts/in) UV light source, suprisingly, legend inks which would normally fail to bond to the laminate surface instead bond with outstanding strength after the UV treatment.

### DETAILED DESCRIPTION OF THE PREFERRED EMBODIEMENT

This invention may be best understod with reference to the following description.

Initial trials were run to evaluate the effects of exposing the unclad side of the laminate to UV light prior to legend printing. The column under "RATING", on Table I, demonstrates adhesion prior to no UV exposure, with UV reflects adhesion after exposure. This rating system is generated from the adhesion by tape test (ASTM D 3359) where the scale is from 0 to 5. A score of 5 indicates that no ink is released onto the tape, a score of 0 indicates that greater than 65% of the ink transfers to the tape.

The "Rating" column shows some degree of ink removal which would be unacceptable unless the material is brushed prior to printing. The UV column (i.e., laminates exposed to UV at approx. 300 mJ/ cm²) has no ink removal and would suggest that some surface chemistry changes have occurred due to the exposure to UV light.

Laminates were also subjected to high UV (frequency near visible light ) and also infrared light. Both trials proved neither types of light would achieve the desired print rating. A time study was conducted to check to see if the surface change was permanent or temporary with time.

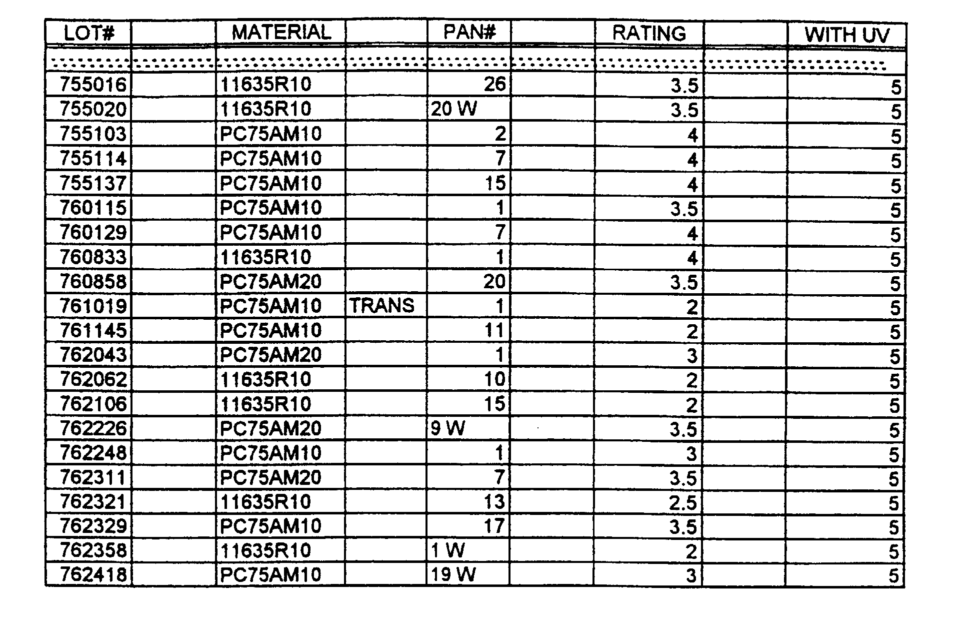

Laminates tested after 80 days still print with no ink removal.

Thus, the use of UV light as an alternative to mechanically scrubbing the unclad side of a pressed lamiriate has been shown to be feasible and also very cost effective. The unique chemistry of the system allows for good release properties at the breakdown of the pressing operations and allows itself to create flinctional groups (good for legend bonding) just by minimal exposure to U.V. radiation.

The chemical mechanism for the photo-chemistry occurring during the irradiation on the single sided laminate is believed to be an o-photo-Fries mechanism. This mechanism was derived from model studies of BPA-epichlorohydrin photo-degradation. The depolymerization upon exposure to UV light forms esters formates (aldehydes) and dicarboxylic acid groups. These functional groups will then act as sites for the UV curable epoxy ink to bond.

Laminates were exposed to different levels of UV by changing the speed of the conveyors on the UV oven. Sample were then surface tested using FTIR analysis (G.E. EMD) and X-ray Photoelectron Spectroscopy (G.E. CRD) . The surface was scan using a Nicolet Magna 550 with a Inspect IR using a germanium ATR crystal . The scan shows a gradual increase in the peak height at the 1740 cm⁻¹ whereas the control board has almost no peak what so ever. This region is usually related to the ester groups (C=O) also called the carbonyl region.

In turn, 3 unclad laminates were analyzed by G.E CRD using XPS. Two of the laminates were exposed to UV (9 ft/min and 24 ft/min) and one was a control (no UV). The elemental surface compositions and their corresponding binding energies are summarized in the attached table.

Other scans demonstrate an increase in the C-O groups and a reduction in C-C as the amount of UV is increased . The amount of oxygen species on the surface increases from 9.6% (control) up to 19.0 % for the laminate exposed to 9 ft/min UV.

The UV curable, etch-resistant ink composition is comprised of a resin formulation of two or more resin components. A first resin component is an acrylated epoxy monomer or dimer. A second resin component is an acrylate having a pendant carboxyl group. In addition to the resins, the ink composition also consists of a photoinitiator and an organic carrier.

The acrylated epoxy monomer or dimer is used as a film former and should provide excellent adhesion to the metal substrate. Without such a component, the ink composition will have noticeably poorer chemical resistance during etching.

The acrylated monomers and dimers may be present in the ink compositions in an amount ranging from about 5% to about 20%, preferably about 10% to about 15%, based on the total weight of the ink composition.

Preferred is a low viscosity, non-volatile, difunctional ester from a low molecular weight epoxy resin, such as Bisphenol A epoxy diacrylate marketed by Henkel under the trademark Photomer 305.

The acrylate having a pendant carboxyl group provides the cured ink with the ability to be stripped from the printed circuit board after the etching process has been completed. Without this resin, the etched message cannot be easily stripped off the substrate, as by use of a basic solution. The acrylate having a pendant carboxyl group may be present in the ink in a amount ranging from about 8% to about 43%, preferably from about 14% to about 20%, based on the total weight of the ink composition.

Preferred acrylates may be employed in the compositions of the present invention include aromatic difunctional acrylates such as Henkel's Photomer 6158 and Henkel's Photomer 6173.

The resin formulation may contain additional resin components. It may contain a resin component or components to promote adhesion, particularly to metal substrates The amount of such an adhesion promoter may range from about 3% to about 10%, but is preferably about 3% to about 5%, based on the total weight of the ink composition Nonyl phenol ethoxylate monoacrylate marketed by Henkel under the trademark Photomer 4003 and Bisphenol A ethoxylate diacrylate marketed by Henkel under the trademark Photomer 4028 are preferred resins.

The resin formulation may also contain resin components which contribute to an improved chemical resistance. The amount of such resin in the composition of the present invention is in a range of about 2% to about 10%, preferably about 4% to about 6%, based on the total weight of the ink composition. Preferred resins are Bisphenol A ethoxylate diacrylate marketed by Henkel under the trademark Photomer 4028 and trimethylol propane propoxylate triacrylate marketed by Henkel under the trademark Photomer 4072.

Other useful resins include those which lower the viscosity of the composition of the present invention. Such resins include 1,6 hexanediol diacrylate (marketed by Radcure).

Preferable resins for lowering viscositv include ethoxylated neopentyl glycol diacrylate marketed by Henkel under the trademark Photomer 4160 and trimethylol propane triacrylate marketed by Radcure.

These viscosity lowering resins are effective when the total amount in the ink composition is from about 10% to about 25%, preferably from about 11% to about 15%, based on the total weight of the ink composition.

The resin formulation may also contain resins which have fast curing properties to provide a quicker cure speed to the ink composition of the present invention. Preferable resins include ethoxylated neopentyl glycol diacrylate marketed by Henkel under the trademark Photomer 4160 and Bisphenol A ethoxylate diacrylate marketed by Henkel under the trademark Photomer 4028.

Effective amounts of these resins range from about 5% to about 15%, preferably from about 1% to about 10%, based on the total weight of the ink composition.

Other useful resins which may be used in the resin formulation are those which provide 'enhanced cross linking. Such resins include 1,4-butanediol diacrylate, 1,4-butanediol dimethacrylate, 1,6-hexamethylene glycol diacrylate, 1,6-hexamethylene dimethacrylate, neopentyl glycol diacrylate, neopentyl glycol dimethacrylate, trimethylol propane triacrylate, trimethylol propane trimethacrylate, pentaerythritol triacrylate, pentaerythritol trimethacrylate, pentaerythritol tetraacrylate, pentaerythritol tetramethacrylate, dipentaerythritol hexaacrylate, dipentaerythritol hexamethacrylate, triethylene glycol triacrylate, triethylene glycol trimethacrylate, urethane acrylate, urethane methacrylates.

Preferred resins which provide enhanced cross linking are trimethylol propane triacrylate marketed by Radcure, ethoxylated neopentyl glycol diacrylate marketed by Henkel under the trademark Photomer 4160 and trimethylol propane propoxylate triacrylate marketed by Henkel under the trademark Photo 4072.

These cross linking enhancing resins are effective in amounts ranging from about 10% to about 20%, preferably from about 12% to about 16%. based on the total weight of the ink composition.

Trimethylol propane propoxylate triacrylate marketed by Henkel as Photomer 4072 is preferred for improving abrasion resistance.

Resins providing abrasion resistance may be present in the composition of the present invention in amounts ranging from about 1% to about 5%, preferably from about 1% to about 2%.

The compositions of the present invention may also contain a photoinitiator. Many such materials are well known to the prior art. The photoinitiator can be any compound that produces a free radical on exposure to radiation such as ultraviolet or visible radiation and thereby initiates a polymerization reaction. Examples of some suitable photoinitiators include anthraquinone and. substituted anthraquinones such as alkyl substituted or halo substituted anthraquinones including 2-tert-butylanthraquinone, 1-chloro-anthraquinone, p-chloroanthraquinone, 2-methylanthraquinone, 2-ethylanthraquinone, octamethylanthraquinone and 2-amylanthraquinone: other substituted or unsubstituted polynuclear quinones including 1,4-naphthoquinone, 9,10-phenanthraquinone, 1,2-benzanthraquinone, 2,3-benzanthraquinone, 2-methyl-1,4-naphthoquinone, 2,3-dichloronaphthoquinone, 1,4-dimethylanthraquinone, 2,3-dimethylanthraquinone, 2-phenylanthraquinone, 2,3-diphenylanthraquinone, 3-chloro-2-methylanthraquinone, retenequinone, 7,8,9,10-tetra-hydronaphthaacenequinone, 1,2,3,4-tetrahydrobenzantracene-7,2-dione, acetophones such as acetophone, 2,2-dimethoxy-2-phenylacetophone, 2,2-diethoxy-2-phenylacetophone, 1,1-dichloroacetophone, 1-hydroxycyclohexylphenylketone, and 2-methyl-1-(4-methylthio) phenyl-2-morpholin-propan-1-one; thioxanthones such as 2-methylthioxanthone, 2-decylthioxanthone, 2-dodecylthioxanthone (DTX), 2-isopropylthioxanthone, 2,4-dimethythioxanthone, 2.4-diethylthioxanthone, 2-chlorothioxanthone, and 2,4-diisopropylthioxanthone; and ketals such as acetophone dimethylketal and benzil dimethylketal; benzoins and benzoin alkyl ethers such as benzoin, benzyl, benzoin methyl ether, and benzoin isopropyl ether, and benzoin isobutyl ether (also known as vicure 10); azo compounds such as azobisisovaleronitrile; and benzophones such as benzophenone, methyl benzophenone, 4,4'-dichlorobenzophenone, 4,4'-bisdiethylaminobenzophenone, Michler's ketone and xanthones. Mixtures of photoinitiators can be employed when desired. The preferred photoinitiator is marketed by Ciba-Geigy under the trademark Irgacure 369 and is chemically 2-benzyl-2-N,N-dimethylamino-1-(4-morpholinophenyl)-1-butanone.

The photoinitiator is present in the ink composition in an amount ranging from about 2% to about 10%, preferably about 2% to about 3%.

The compositions of the present invention also utilize one or more organic carriers. One typical carrier is a mixture of a lower alcohol and a lower ketone, each preferably having no more than ten carbon atoms. Alcohols which typify those which are useful are methanol and ethanol. Useful ketones in the present invention include aliphatic ketones having no more than ten carbon atoms, in straight or branched chain arrangement, such as acetone, methyl ethyl ketone, methyl isobutyl ketone, or an alicyclic ketone such as cyclopentanone, cyclohexanone, or other alicyclic ketones having up to ten carbon atoms. The preferred organic carrier is a mixture of methanol and methyl ethyl ketone.

The carrier employed usually is in the range of about 40% to about 90% by weight of the ink composition, and in the preferred practice is in the range of about 30% to about 60% by weight of the ink composition.

The compositions of the present invention may also contain conductivity agents. If present, they are present in amounts of from about 0.2% to about 2.0%. Examples of suitable conductivity agents include dimethylamine hydrochloride, diethylamine hydrochloride, lithium nitrate, and hydroxylamine hydrochloride. The preferred conductivity agent is lithium nitrate.

Surfactants may also be used in the ink compositions of the present invention to modify the surface tension of the compositions. If present, they may be present in the ink composition in amounts of from about 0.01% to about 0.2%. The preferred surfactant is a non-ionic surfactant such as fluorinated alkyl esters like FC-430, a surfactant from 3M.

The compositions of the present invention may also include photosensitizers. The photosensitizers increase sensitivity by absorbing light of the wavelengths to which it best responds. Many such materials are well known to the prior art. If present, they are present in amounts ranging from about 0.25% to about 5%.

Examples of some suitable photosensitizers include all of the photoinitiators mentioned above; halogen-type sensitizers such as carbontetrachloride, bromoform and carbontribromide; benzoic esters such as ethyl-4-dimethylaminobenzoate and 2-(dimethylamino)ethylbenzoate; tertiary amines such as triethyl amine and triethanol amine; benzotriazole, benzoin, chloranil, benzil, diacetyl, 5-nitrosalicylaldehyde, 2,4-dinitrotoluene. The preferred photosensitizer is 2-isopropylthioxanthone sold by Biddle Sawyer under the trademark Quantacure ITX.

Photostabilizers may also be employed in the compositions of the present invention to prevent polymerization of the compositions when exposed to natural light. They may be present in the ink composition in amounts ranging from about 0.01% to about 0.1%. The preferred photostabilizer is p-methoxyphenol.

The ink composition of the present invention may contain a corrosion inhibitor in sufficient quantity to inhibit corrosion of metal placed in contact with the ink, without adversely affecting the printing characteristics of the ink.

Suitable corrosion inhibitors include from 0.5% to 5% of an essentially basic, heat-stable, metallo-organic sulphonate compound. The sulphonate compound may be selected from the group consisting of ammonium dinonyl naphthalene sulphonate, basic barium dinonyl naphthalene sulphonate, neutral barium dinonyl naphthalene sulphonate, ethylene diamine dinonyl naphthalene sulphonate, basic barium sulphonate naphthalene sulphonate, over based sulphurized calcium alkyl phenate, basic calcium sulphonate, over based calcium sulphonate and highly over based calcium sulphonate. In addition, suitable corrosion inhibitors may be from 0.1% to 5% of an alkyl amine. Typical examples of alkylamines are dipropyl amine, diethylamine and dibutyl amine.

Inks which may be used in the present invention may also comprise other additives, which may be any substance that can enhance the ink with regard to (I) improved solubility of other components, (ii) improved print quality, (iii) improved adhesion of the ink to the media, and (iv) control of wetting characteristics, which may be related to such properties as surface tension and viscosity, among other properties.

In addition, other optional additives such as dispersing agents may be present. If present, they may be present in the ink in amounts of from about 0.01 to about 20 percent by weight. Further, plasticizers such as pentaerythritol tetrabenzoate, commercially available as Benzoflex S552 (Velsicol Chemical Corporation, Chicago, III.), trimethyl citrate, commercially available as Citroflex I (Monflex Chemical Company, Greensboro. N.C.), N,N-dimethyl oleamide. commercially available as Halcomid M-18-OL (C. P. Hall Company, Chicago, III.), and the like, may be present.

The inks used in this invention can be used as a clear ink without the addition of a colorant. If the ink is desired to be visible (for example, to make sure this ink after curing and etching was completely stripped) colorants can be added. Typically, if colorants are present in the ink, they are used in an amount ranging from about 0.5% to 4%, preferably about 1% to about 3%. Colorants which may be employed in the present invention include Morfast black A, Morfast black 101, Morfast red 102, and Morfast yellow 102. The above dyes are available from Morton International. Also, Hektoblack X-2 (from BASF) can be used. In addition, Milliken Chemicals offers Milliken blue A45-1, Milliken red A45-2, and Milliken yellow A45-3. The preferable colorant for the present invention is the Milliken red A45-2.

While not essential to the practice of the present invention, the ink composition of this invention can also be formulated to include evaporation retardants, also known as humectants. These compounds prevent the ink jet orifice from drying or crusting. Typical classes of humectants include glycol ethers and glycol esters or combinations thereof. Specific examples are compounds such as ethylene glycol and propylene glycol methyl ether.

The formulated jet inks of the present invention will exhibit the following characteristics: (1) a viscosity from about I to about 10 centipoises (cps) at 25o C., (2) an electrical resistivity from about 50 to about 2.000 ohms-cm-<- 1>, (3) a sonic velocity from about 1.200 to about 1.700 m/sec., and (4) a surface tension below 28 dynes/cm. Electrolytes can be added to adjust the specific resistivity of the ink. Usable electrolytes include dimethylamine hydrochloride and hydroxylamine hydrochloride. The modifications of the principal components of the ink compositions. as disclosed above, to achieve these desired operational characteristics is well within the skill in the art.

The viscosity of the jet ink composition is generally from about I to about 10 centipoise. and preferably from about 2 to about 5 centipoise. Various, known viscosity modifying agents may be added, in addition to any acrylate resins capable of lowering viscosity, as needed to adjust the viscosity of any given ink formulation. Additionally, the jet ink composition should enable printed images with sufficient flexibility to prevent cracking or creasing.

It will be understood by those of skill in the art that the disclosed method has far broader application that merely the affixation of legend inks to printed circuit boards. Thus, it should be appreciated that the UV pretreatment of the present invention will work with other thermoplastics and other inks or coatings. For example. the present process would be useful in the preparation of molded epoxy parts prior to the application of epoxy paints. Many additional applications will be immediately apparent to those of skill in the art.

## Claims

1. An improved method for affixing a legend ink to a laminate, said method comprising the steps of:
(a) treating the unclad side of said laminate with ultraviolet light; and
(b) thereafter printing a legend ink on said treated laminate.

2. A method according to claim 1, wherein said ultraviolet light is wide spectrum high intensity ultraviolet light ranging from about 100 to 400 watt/in.

3. A method according to claim 1, wherein said laminate treating step results in exposure to said ultraviolet light greater than about 10 mJ/cm².

4. A method according to claim 1, wherein said laminate treating step results in exposure to said ultraviolet light of about 300 mJ/cm².

5. An improved method for affixing legend ink to a printed circuit board, said method comprising the steps of:
(a) exposing the unclad side of said board with wide spectrum high intensity ultraviolet light ranging from about 100 to about 400 watt/in. to yield a level of exposure ranging from about 100 to about 150 mJ/cm²; and
(b) thereafter printing legend ink on said exposed board.

6. A method according to claim 5, wherein said exposure level is about 300 mJ/cm².

7. An improved printed circuit board, the improvement therein being the enhanced ability of said board to bond with a legend ink through the pretreatment of said board with ultraviolet light.

8. An improved laminate for use in a printed circuit board, the improvement therein being the enhanced ability of said laminate to bond with a legend ink through the pretreatment of said laminate with ultraviolet light.

9. An improved method for affixing an ink to a thermoplastic part, said method comprising the steps of:
(a) treating said part with ultraviolet light; and
(b) thereafter printing an ink on said treated part.

10. A method according to claim 9 wherein said ultraviolet light is wide spectrum high intensity ultraviolet light ranging from about 100 to about 400 watt/in.
